Europäisches Patentamt

European Patent Office

Office européen des brevets

(11) Veröffentlichungsnummer: **0 254 140 B1**

(12) **EUROPÄISCHE PATENTSCHRIFT**

(45) Veröffentlichungstag der Patentschrift: **17.04.91**

(51) Int. Cl.5: **H03M 13/00, G06F 11/10**

(21) Anmeldenummer: **87109882.8**

(22) Anmeldetag: **08.07.87**

(54) **Verfahren zum Bilden von Datenblocksicherungsinformationen für serielle Datenbitfolgen mittels zyklischer Binärcodes.**

(30) Priorität: **21.07.86 DE 3624599**

(43) Veröffentlichungstag der Anmeldung:
**27.01.88 Patentblatt 88/04**

(45) Bekanntmachung des Hinweises auf die
Patenterteilung:
**17.04.91 Patentblatt 91/16**

(84) Benannte Vertragsstaaten:
**AT BE CH DE FR GB IT LI NL SE**

(56) Entgegenhaltungen:
**EP-A- 0 074 627**
**DE-A- 2 445 508**

**IEEE TRANSACTIONS ON INFORMATION
THEORY, Band IT-15, Nr. 1, Januar 1969, Seiten 109-113, New York, US; R.T. CHIEN:
"Burst-correcting codes with high-speed decoding"**

**IEE PROCEEDINGS, SECTION A-I, Band 130,
Nr. 5, Teil F, August 1983, Seiten 468-475, Old
Woking, Surrey, GB; E. OLCAYTO et al.:
"Class of linear cyclic block codes for burst
errors occurring in one-, two- and threedimensional channels"**

**IBM TECHNICAL DISCLOSURE BULLETIN,
Band 8, Nr. 4, September 1965, Seiten
535-538, New York, US; W.F. ROGERS:
"Character cyclic codes"**

**PROCEEDINGS OF IEE, Band 117, Nr. 4, April
1970, Seiten 681-686, New York, US; D.H.
GREEN et al.: "Nonlinear product-feedback
shift registers"**

(73) Patentinhaber: **Siemens Aktiengesellschaft
Wittelsbacherplatz 2
W-8000 München 2(DE)**

(72) Erfinder: **v. Sichart, Frithjof, Dr.-Phys.
Karl-Theodor-Strasse 72
W-8000 München 40(DE)**
Erfinder: **Hollstein, Christian
Schlesierstrasse 15
W-4514 Ostercappeln(DE)**
Erfinder: **Kirchberger, Klaus
Bannwaldseestrasse 35
W-8000 München 70(DE)**

## Beschreibung

Die Erfindung betrifft ein Verfahren zur Datensicherung bei der Übertragung serieller Datenbitfolgen mittels Bildung von Datenblocksicherungsinformationen mit Hilfe zyklischer Binärcodes in jeweils einem sendeseitigen und einem empfangsseitigen Codierwerk, in denen jeweils die Glieder des Binärcodepolynoms repräsentierende Register und binäre Verknüpfungsglieder derart angeordnet sind, daß die binären Blocksicherungsinformationen mittels einer binären Rechenoperation mit einem durch die Bitfolge eines Datenblockes definierten Nachrichtenpolynom und einem den zyklischen Binärcode repräsentierenden Binärcodepolynom eines Grades G und definierten Termen in Form des dabei entstehenden Rechenoperationsrestes ermittelt sowie sendeseitig seriell an das Datenblockende angefügt und empfangsseitig parallel zu den empfangenen Blocksicherungsinformationen einem im Sinne der Fehlererkennung eingesetzten Vergleicher zugeführt werden.

Die Datensicherung von zu übertragenden seriellen Datenbitfolgen erfolgt in der Informationstechnik in überwiegendem Maße durch Blocksicherungsverfahren mittels zyklischer Binärcodes. Die Verwendung zyklischer Binärcodes in Blocksicherungsverfahren dient vorzugsweise einer wirksamen Fehlererkennung bei der Übertragung von seriellen Datenbitfolgen über gestörte Übertragungswege. In der Zeitschrift 'Elektronik', 1976, Seite 55 bis 59, sind ein derartiges Datensicherungsverfahren mittels zyklischer Binärcodes sowie schaltungstechnische Realisierungsmöglichkeiten beschrieben. Die Datenblocksicherungsinformationen für einen Block bzw. für eine definierte Anzahl von zu übertragenden Datenbits werden durch die Division eines die Datenbitfolge repräsentierenden Nachrichtenpolynoms durch ein den zyklischen Binärcode repräsentierendes Generatorpolynom ermittelt. Der dabei gewonnene Divisionsrest wird als Datenblocksicherungsinformation sendeseitig seriell an die Datenbitfolge angefügt und übertragen. Empfangsseitig werden aus der empfangenen Datenbitfolge erneut mittels des bekannten Datenblocksicherungsverfahrens die Blocksicherungsinformationen ermittelt und mit den sendeseitig erzeugten und übertragenen Datenblocksicherungsinformationen verglichen. Bei fehlerfreier Übertragung der Datenbitfolge stimmen die Datenblocksicherungsinformationen überein und bei fehlerhafter Übertragung können mittels des Vergleichsergebnisses das Vorliegen eines Fehlers erkannt und Rückschlüsse auf die Art des Fehlers, wie z. B. Einzelfehler, Doppelfehler oder Fehlerbündel, gezogen werden. Die Datenblocksicherungsinformationen werden in einem aus mehreren hintereinander geschalteten Registern bestehenden Codierwerk erzeugt. Jedem Register wird in aufsteigender Reihenfolge eine Polynomordnungszahl entsprechend dem Binärcodepolynom zugeordnet, womit jedes Register ein Glied des Binärcodepolynoms darstellt. Nach denjenigen Registern, die ein mit Termen versehenes Glied des Binärcodepolynoms repräsentieren, ist jeweils ein binäres Divisionsglied - schaltungstechnisch realisiert durch einen Exklusiv-Oder bzw. Halbaddierer-Schaltkreis - eingefügt. Jeweils ein Eingang und die Ausgänge der Verknüpfungsglieder sind jeweils mit den Ausgängen der vorgeordneten bzw. mit den Eingängen der nachgeordneten Register verbunden. Der Ausgang des mit der höchsten Polynomordnungszahl versehenen Registers ist mit dem Eingang eines weiteren Divisionsgliedes verbunden. An den zweiten Eingang dieses Divisionsgliedes wird die zu sichernde Datenbitfolge herangeführt. Der Ausgang dieses Divisionsgliedes ist mit allen jeweils zweiten Eingängen der Divisionsglieder sowie mit dem Eingang des mit der niedrigsten Polynomordnungszahl versehenen Registers verbunden. Die Taktung der Register erfolgt durch den Bittakt der Datenbitfolge. Dieses Verfahren wird vorzugsweise in Codierwerken realisiert, die aus mehreren diskreten Schaltkreisen gebildet oder die in einem maskenprogrammierbaren integrierten Schaltkreis - einem sogenannten "kundenspezifischen" Schaltkreis -implementiert sind. Bei niedrigeren Übertragungsgeschwindigkeiten kommen auch rechnergesteuerte Codierwerke zum Einsatz. Die in der Kommunikationstechnik stetig zunehmende Menge von in kürzester Zeit zu übertragenden Daten führt zu einer ständigen Erhöhung der Übertragungsgeschwindigkeiten, wodurch eine leistungsverbrauchsintensive diskrete Schaltkreistechnik erforderlich ist und das Implementieren in einen maskenprogrammierbaren integrierten Schaltkreis nur mehr bedingt und die Realisierung in einem rechnergesteuerten Codierwerk nicht mehr möglich ist.

Der Erfindung liegt die Aufgabe zugrunde, ein Verfahren zum Bilden von Datenblocksicherungsinformationen für ein Codierwerk anzugeben, mittels dem die erforderliche Verlustleistung bei Einsatz diskreter Schaltkreise verringert und die Realisierung in einem maskenprogrammierbaren integrierten Schaltkreis oder in einem rechnergesteuerten Codierwerk ermöglicht wird. Diese Aufgabe wird ausgehend von dem eingangs beschriebenen Verfahren durch die kennzeichnenden Merkmale des Anspruches 1 gelöst.

Der Vorteil der Erfindung liegt insbesondere darin, daß unter Beibehaltung derselben mathematischen Regeln und Schaltungskomponenten der Verarbeitungstakt zum Bilden der Blocksicherungsinformationen durch paralleles Verarbeiten von Informationen mehrerer Datenbits und von Informationen an den Ausgängen der mit den höchsten Ordnungszahlen versehenen Registern reduziert wird, die in mehreren parallelen Registerketten angeordnet sind. Die Anzahl der Registerketten sowie die Aufteilung der Register auf die einzelnen Registerketten und die Zuordnung der Polynomordnungszahlen zu den einzelnen Registern orientiert sich ausschließlich an der zu erzielenden Verarbeitungstaktreduzierung. Die maximale Verarbeitungstaktreduzierung wird gemäß Anspruch 2 für eine vorgegebene Anzahl von Registerketten dann erreicht, wenn die Anzahl von hintereinandergeschalteten Registern je Registerkette gleich gewählt ist, die Anzahl der Registerketten einem ganzzahligen Teil des Grades G des Binärcodepolynoms entspricht und die Polynomordnungszahlen einzeln zyklisch auf die Registerketten verteilt werden. Bei einer derartigen Registerkettenanordnung entspricht die Anzahl k der Registerketten der Anzahl k von seriell in die Serien-Parallel-Umsetzeinrichtung einzulesenden Datenbits. Außerdem stimmt die Anzahl k von Registerketten mit der Anzahl von Registerausgängen mit den höchsten Ordnungszahlen überein, wobei diese Registerausgänge mit den Registerkettenausgängen identisch sind.

Die vorteilhaften Weiterbildungen der Erfindung gemäß der Patentansprüche 3 und 4 setzen eine Registerkettenanordnung gemäß Patentanspruch 2 voraus. Wird eine nicht mehr gleichmäßige Aufteilung der Register auf die Registerketten gewählt, um z. B. eine vorgegebene Verarbeitungsgeschwindigkeit zu erreichen, so gelten die gemäß Patentanspruch 4 angegebenen Regeln zum Bilden der Verknüpfungsinformation weiterhin generell zwischen jeweils zwei Registern einer Registerkette, jedoch treten anstelle der Informationen an den Registerkettenausgängen die Informationen der Ausgänge der die höchsten Polynomordnungszahlen repräsentierenden Register.

Im Rahmen einer vorteilhaften Weiterbildung der Erfindung gemäß Patentanspruch 6 ist im sendeseitigen Codierwerk eine Multiplexeinrichtung vorgesehen, die im Datenbittakt der Datenbitfolge die Ausgänge der Registerketten zyklisch abtastet, wodurch die Datenblocksicherungsinformationen bitweise aus den Registerketten ausgelesen werden und am Ausgang der Multiplexeinrichtung seriell zur Verfügung stehen. Diese Multiplexeinrichtung nimmt neben der Serien-Parallel-Umsetzung der Datenblocksicherungsinformationen die Transformation der verschiedenen Bittaktgeschwindigkeiten der Datenblocksicherungsinformationen vor.

Die in den vorteilhaften Weiterbildungen gemäß den Ansprüchen 6 und 7 angegebenen Verfahren zum Vergleich der beiden Datenblocksicherungsinformationen unterscheiden sich generell in der Qualität der Vergleichsergebnisse. Bei dem Verfahren gemäß Anspruch 6 enthält das Vergleichsergebnis detaillierte Informationen über Art und Anzahl der Fehler einer Datenbitfolge-Übertragung, was in der Vergleichseinrichtung aufgrund der detaillierten Untersuchung der Blocksicherungsinformationen einen erheblichen schaltungstechnischen Aufwand bedeutet. Bei dem Verfahren gemäß Anspruch 7 kann eine Information gebildet werden, die lediglich die fehlerfreie oder fehlerhafte Übertragung einer Datenbitfolge anzeigt. Da überwiegend beim Auftreten eines Übertragungsfehlers die Datenbitfolge wiederholt übertragen werden muß, kann auf eine detaillierte Information über Art und Häufigkeit der Übertragungsfehler verzichtet werden. Diese Weiterbildung ist besonders vorteilhaft, da die Systemkomponenten, die zum Bilden der Datenblocksicherungsinformation benutzt werden, auch zum Vergleich der sende- und empfangsseitig gebildeten Datenblocksicherungsinformationen herangezogen werden und mittels einer schaltungstechnisch einfach zu realisierenden Auswerteschaltung das Vergleichsergebnis bewertet und eine Information über die Übertragungsqualität geliefert wird.

Im folgenden wird ein Ausführungsbeispiel der Erfindung anhand der Zeichnung näher erläutert.

Für das Ausführungsbeispiel wurde ein Binärcodepolynom zugrundegelegt, das für die Bildung der Datenblocksicherungsinformation für die zu übertragende Bitfolge in einer Ringleitungs-Zugriffssteuerung für ein lokales Netz vorgesehen ist und im ANSI/IEEE 802.5-Standard wie folgt definiert ist:

$$G(X) = x^{32} + x^{26} + x^{23} + x^{22} + x^{16} + x^{12} + x^{11} + x^{10} + x^8 + x^7 + x^5 + x^4 + x^3 + x + 1.$$

Dieses Binärcodepolynom mit dem Grad 32 weist 15 Terme auf, wobei jeder Term ein mit dem Koeffizientenwert 1 versehenes Polynomglied darstellt. Die Anzahl der erforderlichen Register hängt wie beim bekannten Verfahren vom Grad des Binärcodepolynoms ab, weshalb im Ausführungsbeispiel 32 Register angeordnet sind. Des weiteren wurde für das Ausführungsbeispiel eine Verarbeitungsgeschwindigkeit der Einrichtung zum Bilden der Datensicherungsinformationen vorausgesetzt, die annähernd der halben Bittaktgeschwindigkeit der Datenbitfolge entspricht. Hierfür ist eine Aufteilung der Register in zwei mit jeweils der gleichen Anzahl von Registern versehenen Registerketten erforderlich.

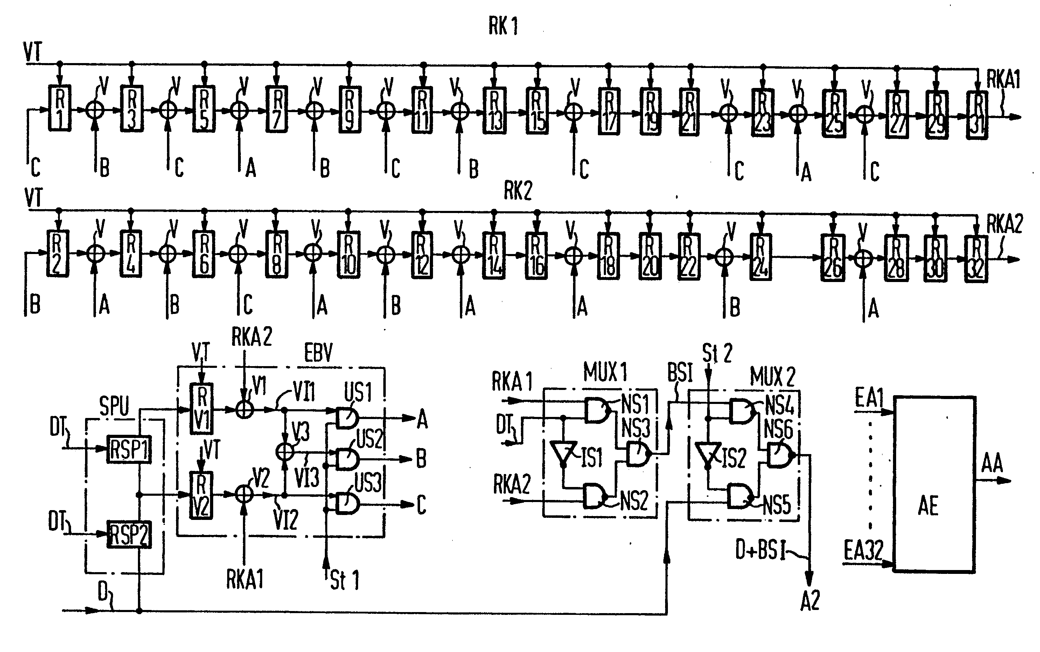

Fig. 1 zeigt die zwei aus jeweils 16 hintereinander geschalteten Registern R bestehenden Registerketten RK1, RK2 sowie die Serien-Parallel-Umsetzeinrichtung SPU, eine Einrichtung zum Bilden der Verknüpfungsinformationen EBV, zwei Multiplexeinrichtungen MUX1 und MUX2 und eine Auswerteeinrichtung AE zum Bewerten der sendeseitig und empfangsseitig erzeugten Datenblocksicherungsinformationen BSI.

Jedes Register R der Registerketten RK1, RK2 stellt ein Glied mit definierter Ordnung des Binärcodepolynoms dar, wobei die Polynomordnungszahlen je Registerkette RK1, RK2 gemäß der Reihenfolge n, n + k, n + 2k, + .. + ,n + (G:k-1)k mit k = 2 (zwei Registerketten) und n gleich der der jeweiligen Registerkette RK1, RK2 zugeordneten Registerkettenzahl - verteilt werden. Repräsentiert ein Register R oder das nach diesem Register R in der Registerkette RK1, RK2 fehlende Register R einen Term des Binärcodepolynoms, so ist nach diesem Register R ein Verknüpfungsglied V eingefügt. Ein Eingang dieses Verknüpfungsgliedes V ist jeweils mit dem Ausgang des vorhergehenden Registers R und der Ausgang des Verknüpfungsgliedes V mit dem Eingang des nachfolgenden Registers R verbunden. Alle Register R werden im Verarbeitungstakt VT der Einrichtung zum Bilden der Datensicherungsinformationen EBV getaktet. Hierfür wird den Takteingängen aller Register R der Verarbeitungstakt VT zugeführt. Der Verarbeitungstakt VT kann von dem Datenbittakt DT der Datenbitfolge D mittels einer nicht dargestellten Einrichtung abgeleitet oder in einer separaten, wiederum nicht dargestellten Takteinrichtung erzeugt werden.

Die zu sichernde Datenbitfolge D wird an den Eingang eines Registers RSP2 geführt und im Datenbittakt DT der Datenbitfolge D bitweise in dieses Register RSP2 und ein nachgeschaltetes Register RSP1 eingelesen und dort gespeichert. Die beiden Register RSP1 bzw. RSP2 stellen die Serien-Parallel-Umsetzeinrichtung SPU dar. Die Ausgänge der beiden Register RSP1 und RSP2 sind mit jeweils einem Eingang von zwei weiteren Registern RV1, RV2 verbunden. Mittels dieser beiden Register RV1, RV2 werden die in der Serien-Parallel-Umsetzeinrichtung SPU gespeicherten Datenbitinformationen im Verarbeitungsbittakt VT ausgelesen und an jeweils einen Eingang von zwei Verknüpfungsglieder V1, V2 weitergeleitet. Der zweite Eingang des ersten Verknüpfungsgliedes V1 wird mit dem Ausgang RKA2 der Registerkette 2 und der zweite Eingang des zweiten Verknüpfungsgliedes V2 mit dem Ausgang RKA1 der Registerkette RK1 verbunden. Im ersten Verknüpfungsglied V1 wird die Information des zuerst eingelesenen Datenbits der Datenbitfolge D mit der Information des Ausgangs RKA2 der Registerkette RK2 binär mittels einer binären Exklusiv-Oder-Funktion verknüpft. Die so ermittelte erste Verknüpfungsinformation VI1 wird denjenigen Verknüpfungsgliedern V der Registerketten RK1, RK2 zugeführt, deren vorhergehendes Register R einen Term des Binärcodepolynoms repräsentiert. Im zweiten Verknüpfungsglied V2 wird ebenfalls durch Verknüpfen der im ersten Register RSP1 eingelesenen Datenbits und der Information des Registerkettenendes RKA1 - Registerkettenausgang RKA1 ist mit dem zweiten Eingang des zweiten Verknüpfungsgliedes V2 verbunden - mittels einer binären Exklusiv-Oder-Funktion bestimmt und an diejenigen zweiten Eingänge der Verknüpfungsglieder V weitergeleitet, deren in der jeweiligen Registerkette RK1, RK2 fehlendes Glied des Binärcodepolynoms einen Term repräsentiert. Die beiden derart ermittelten Verknüpfungsinformationen VI1,VI2 gelangen über die jeweiligen Ausgänge der beiden Verknüpfungsglieder V1, V2 an jeweils einen Eingang eines dritten Verknüpfungsgliedes V3. Mittels der im dritten Verknüpfungsglied V3 implementierten Exklusiv-Oder-Funktion wird eine dritte Verknüpfungsinformation VI3 gebildet, die an diejenigen Verknüpfungsglieder V der Registerketten RK1, RK2 weitergeleitet werden, deren vorhergehendes Register R als auch deren fehlendes Glied der jeweiligen Registerkette RK1, RK2 jeweils einen Term des Binärcodepolynoms repräsentieren. Alle drei Verknüpfungsinformationen VI1, VI2, VI3 gelangen über entsprechend angeordnete Leitungen an jeweils einen Eingang von drei binären UND-Schaltungsglieder US1, US2, US3. Die jeweils zweiten Eingänge der UND-Schaltungsglieder US1, US2, US3 sind untereinander und mit einem Steuereingang ST1 der Einrichtung zum Bilden der Verknüpfungsinformationen EBV verbunden. Über diesen Steuereingang ST1 kann durch entsprechendes Anlegen einer binären Information die Weitergabe der drei Verknüpfungsinformationen VI1, VI2, VI3 an die Ausgänge der UND-Schaltungsglieder US1, US2, US3 bzw. an die Ausgänge A, B und C der Einrichtung zum Bilden der Verknüpfungsinformation EBV verhindert werden. Dies ist z. B. während des Auslesevorgangs der Datenblocksicherungsinformationen BSI aus den Registerketten RK1, RK2 erforderlich. Der Ausgang A der Einrichtung zum Bilden der Verknüpfungsinformation EBV ist über entsprechend angeordnete und nicht dargestellte Leitungen mit den jeweils zweiten und mit A gekennzeichneten Eingängen der Verknüpfungsglieder V der beiden Registerketten RK1, RK2 verbunden. Ebenso ist der Ausgang B bzw. Ausgang C der Einrichtung zum Bilden der Verknüpfungsinformationen EBV mit jeweils den zweiten und mit B bzw. C gekennzeichneten Eingängen der Verknüpfungsglieder V der beiden Registerketten RK1, RK2 verbunden.

Die beiden Ausgänge RKA1, RKA2 der Registerketten RK1, RK2 sind des weiteren mit jeweils einem Eingang einer ersten Multiplexeinrichtung MUX1 bzw. jeweils einem Eingang zweier binärer NAND-Schaltungsglieder NS1, NS2 verbunden. Die jeweils zweiten Eingänge dieser NAND-Schaltungsglieder NS1, NS2 werden an einen Ausgang bzw. Eingang eines Invertierungs-Schaltungsgliedes IS1 geführt Der Eingang des binären Invertierungs-Schaltungsgliedes IS1 stellt zugleich den Eingang für den Datenbittakt DT der Datenbitfolge D dar. Die beiden Ausgänge der NAND-Schaltungsglieder NS1, NS2 sind mit jeweils einem Eingang eines dritten NAND-Schaltungsgliedes NS3 verbunden. Diese drei NAND-Schaltungsglieder NS1, NS2 und NS3 sowie das Invertierungs-Schaltungsglied IS1 bilden die erste Multiplexeinrichtung MUX1, mit der die Datenblocksicherungsinformationen BSI im Datenbittakt DT der Datenbitfolge D zyklisch aus beiden Registerketten RK1, RK2 ausgelesen werden und über den Ausgang der Multiplexeinrichtung MUX1 - Ausgang des NAND-Schaltungsgliedes NS3 ist gleich dem Ausgang der Multiplexeinrichtung MUX1 - an den Eingang einer weiteren Multiplexeinrichtung MUX2 gelangen. Diese zweite Multiplexeinrichtung MUX2 weist ebenfalls drei NAND-Schaltungsglieder NS4, NS5, NS6 und ein Invertierungs-Schaltungsglied IS2 auf und ist schaltungstechnisch gemäß der Multiplexeinrichtung MUX1 aufgebaut. An den zweiten Eingang dieser Multiplexeinrichtung MUX2 wird über eine entsprechend angeordnete Leitung die Datenbitfolge D herangeführt. Durch Anlegen entsprechender Steuerinformationen an einen mit dem Invertierungs-Schaltungsgliedes IS2 verbundenen Steuereingang ST2 wird nach Durchlaufen der zu sichernden Datenbitfolge D durch die zweite Multiplexeinrichtung MUX2 die Datenblocksicherungsinformation BSI an den Ausgang A2 dieser Multiplexeinrichtung MUX2 gesteuert. Alle bisher erläuterten Systemkomponenten und ein nicht dargestelltes Steuerwerk bilden zusammen ein sendeseitiges Codierwerk. Dem Steuerwerk obliegt die Aufgabe, die Multiplexeinrichtungen MUX1, MUX2 sowie die Einrichtung zum Bilden der Verknüpfungsinformation EBV derart zu steuern, daß während des Übertragens einer zu sichernden und eine definierte Anzahl aufweisende Datenbitfolge D die Datenblocksicherungsinformation BSI mittels der beiden Registerketten RK1, RK2 und der Einrichtung zum Bilden der Verknüpfungsinformationen EBV gebildet wird und die so ermittelten Datenblocksicherungsinformationen BSI mittels der Multiplexeinrichtungen MUX1, MUX2 zeitgerecht an die Datenbitfolge D angefügt bzw. übertragen werden.

In einem empfangsseitigen Codierwerk wird die Datenblocksicherungsinformation BSI in gleicher Weise wie in dem sendeseitigen Codierwerk ermittelt, wofür die Systemkomponenten wie die beiden Registerketten RK1, RK2 sowie die Einrichtung zum Bilden der Verknüpfungsinformation EBV und die Serien-Parallel-Umsetzeinrichtung SPU - in gleicher Weise angeordnet - erforderlich sind. Zusätzlich obliegt dem empfangsseitigen Codierwerk die Aufgabe, die empfangsseitig gebildeten und die sendeseitig gebildeten und übertragenen Datenblocksicherungsinformationen BSI zu vergleichen und bei Ungleichheit der beiden Datenblocksicherungsinformationen BSI eine entsprechende Information zu bilden. Hierzu wird die in dem empfangsseitigen Codierwerk gebildete und in den beiden Registerketten RK1, RK2 gespeicherte Datenblocksicherungsinformation BSI durch die sendeseitig gebildete Datenblocksicherungsinformation BSI mittels des erfindungsgemäßen Verfahren binär dividiert. Der Divisionsrest dieser binären Division weist bei fehlerfreier Übertragung der Datenbitfolge D den binären Wert Null auf und somit liegt auch an allen Ausgängen aller Register R der beiden Registerketten RK1, RK2 eine den binären Wert Null repräsentierende Information vor. Die Ausgänge aller Register R werden auf die Eingänge EA1 bis EA32 einer Auswerteeinrichtung AE geführt. In dieser Auswerteeinrichtung AE wird mittels einer Kaskadenschaltung mehrerer binärer AND- und NAND-Schaltungsglieder festgestellt, ob an allen Ausgängen der Register R die die binäre Null repräsentierende Information vorliegt. Weisen alle Eingänge EV1 bis EV32 der Auswerteeinrichtung AE eine die binäre Null repräsentierende Information auf, so tritt am Ausgang AA der Auswerteeinrichtung AE eine Information auf, die die fehlerfreie Übertragung der zuletzt empfangenen Datenbitfolge D kennzeichnet. Ergibt sich aus der Division der beiden Datenblocksicherungsinformationen BSI ein Divisionsrest ungleich der binären Null, so gelangt an den Ausgang AA der Auswerteeinrichtung AE eine die fehlerhafte Übertragung der zuletzt empfangenen Datenbitfolge D kennzeichnende Information. Dieses Verfahren hinsichtlich des Vergleichs der beiden Datenblocksicherungsinformationen BSI ist mit einem Minimum an zusätzlichem Schaltungsaufwand zu realisieren, da der Vergleich der beiden Datenblocksicherungsinformationen BSI in derselben Weise wie die Bildung der Datenblocksicherungsinformation durchgeführt wird und anschließend mittels einfacher binärer Schaltungsglieder eine Auswertung des Divisionsrestes der Division der beiden Datenblocksicherungsinformationen BSI stattfindet. Da bei Auftreten eines oder mehrerer Fehler während der Übertragung einer Datenbitfolge D diese wiederholt übertragen werden muß, kann auf eine Untersuchung der Art und Häufigkeit der Übertragungsfehler verzichtet werden. Selbstverständlich kann dieser Vergleich stattdessen in einer nicht dargestellten, jedoch wesentlich komplexer aufgebauten Vergleichereinrichtung durchgeführt werden.

Um alle Register R vor jedem Bilden einer Datenblocksicherungsinformation BSI für eine beliebige Datenbitfolge D in einen definierten Betriebszustand - an allen Ausgängen der Register R liegt die Information, die den binären 1-Zustand repräsentiert - zu bringen, wird vor jedem Register R ein binäres NAND-Schaltungsglied - nicht dargestellt - eingefügt. Ein Eingang dieses NAND-Schaltungsgliedes ist jeweils mit dem Ausgang des vorhergehenden Registers R oder dem Ausgang des vorhergehenden Verknüpfungsgliedes V verbunden. Der Ausgang des NAND-Schaltungsgliedes wird zum Eingang des jeweiligen Registers R geführt. Alle jeweils zweiten Eingänge der NAND-Schaltungsglieder sind untereinander und mit der Steuereinrichtung verbunden. Durch zeitgerechtes Anlegen einer Information, die der binären 1 entspricht, werden die Ausgänge der NAND-Schaltungsglieder und die Ausgänge der Register R vor dem Bilden einer weiteren Datenblocksicherungsinformation BSI in eine einen definierten Ausgangszustand geschaltet. Alle Register R sind durch Flip-Flop-Schaltungsglieder realisiert.

Alle vorhergehend erläuterten Systemkomponenten lassen sich sowohl mit diskreter Schaltkreistechnik als auch in einem maskenprogrammierbaren integrierten Schaltkreis oder als Befehlsfolge in einem programmgesteuerten Rechnersystem realisieren.

**Ansprüche**

1. Verfahren zur Datensicherung bei der Übertragung serieller Datenbitfolgen (D) mittels Bildung von Datenblocksicherungsinformationen (BSI) mit Hilfe zyklischer Binärcodes in jeweils einem sendeseitigen und einem empfangsseitigen Codierwerk, in denen jeweils die Glieder des Binärcodepolynoms repräsentierende Register (R) und binäre Verknüpfungsglieder (V) derart angeordnet sind, daß die binären Blocksicherungsinformationen mittels einer binären Rechenoperation mit einem durch die Binärfolge eines Datenblockes definierten Nachrichtenpolynom und einem den zyklischen Binärcode repräsentierenden Binärcode-Polynom eines Grades G und definierten Termen in Form des dabei entstehenden Rechenoperationsrestes ermittelt sowie sendeseitig seriell an das Datenblockende angefügt und empfangsseitig parallel zu den empfangenen Blocksicherungsinformationen einem im Sinne der Fehlererkennung eingesetzten Vergleicher (AE) zugeführt werden,
**dadurch gekennzeichnet,**
daß die Register (R) hintereinander in Registerketten (RK) angeordnet sind, deren Anzahl k mindestens dem Verhältnis vom Bittakt der Datenbitfolgen (D) zu dem zum Bilden der Blocksicherungsinformationen vorgesehenen reduzierten Verarbeitungstakt (VT) des Codierwerks entspricht, daß die Register (R) in der aufsteigenden Reihenfolge der ihnen zugeordneten Polynomordnungszahlen 1 bis G entsprechend zyklisch auf die Registerketten (RK) verteilt sind bzw. sofern k>2 gewählt ist, entweder einzeln oder zumindest teilweise gruppenweise auf die Registerketten (RK) verteilt sind, daß die Registerketteneingänge und eine von der Registerkettenzahl und von der einzelnen oder gruppenweise zyklischen Polynomordnungszahl-Verteilung abhängige Anzahl von Registerausgängen der mit den höchsten Ordnungszahlen versehenen Register (R) auf eine Einrichtung zum Bilden von Verknüpfungsinformationen (EBV) geführt werden, daß nach einem einen Term repräsentierenden Register (R) oder zwischen die Register (R) in Abhängigkeit vom Vorhandensein mindestens eines Termes bei den fehlenden Gliedern des Binärcodepolynoms ein Verknüpfungsglied (V) eingefügt wird, daß eine ebenfalls von der Registerkettenzahl und von der einzelnen oder gruppenweise zyklischen Polynomordnungszahl-Verteilung abhängige Anzahl von Datenbits der seriellen Datenbitfolge (D) seriell mit der Bittaktgeschwindigkeit (DT) der Datenbitfolge (D) in eine Serien-Parallel-Umsetzeinrichtung (SPU) eingelesen wird, daß mit dem Verarbeitungstakt (VT) die Datenbits aus der Serien-Parallel-Umsetzeinrichtung (SPU) ausgelesen und über eine der Anzahl der eingelesenen Datenbits entsprechende Anzahl von Leitungen an die Einrichtung zum Bilden der Verknüpfungsinformationen (EBV) weitergeleitet werden, daß in der Einrichtung zum Bilden der Verknüpfungsinformationen (EBV) die jeweiligen Verknüpfungsinformationen (VI) für die jeweiligen Verknüpfungsglieder (V) gebildet und über hierfür vorgesehene Verbindungen den einzelnen Verknüpfungsgliedern (V) und Registerketteneingängen zugeführt werden, sowie daß die Verknüpfungsinformationen (VI) in Abhängigkeit von der Anzahl und Lage der Terme bei oder vor den Registern (R) der Registerkette (RK) jeweils in der Polynomordnungszahlreihe fehlenden Glieder des Binärcodepolynoms durch binäre Rechenoperationen mittels der an den Ausgängen der mit den höchsten Polynomordnungszahlen versehenen Registern (R) vorliegenden und den die Datenbits enthaltenden Informationen innerhalb einer Verarbeitungstaktperiode (VT) gebildet werden.

2. Verfahren nach Anspruch 1, **dadurch gekennzeichnet,** daß die Anzahl von hintereinandergeschalteten Registern (R) je Registerkette (RK1, RK2) gleich gewählt wird, daß die Anzahl k der Registerketten (RK1, RK2) einem ganzzahligen Teil des Grades G des Binärcodespolynoms entspricht und daß die Polynomordnungszahlen einzeln zyklisch den Registerketten (RK1, RK2) zugeordnet werden.

3. Verfahren nach einem der vorhergehenden Ansprüche, **dadurch gekennzeichnet, daß** bei einer die gleiche Anzahl von Registern (R) aufweisenden und einer ganzzahligen Teilzahl des Grades G der Binärcodepolynome entsprechenden Anzahl k von Registerketten (RK1, RK2) die Polynomordnungszahlen je Registerkette (RK1, RK2) gemäß der Reihenfolge n, n+k, n+2k..+n+(G/k-1)k zugeordnet werden, wobei in der der jeweiligen Registerkette (RK1, RK2) zugeordneten Registerkettenzahl entspricht.

4. Verfahren nach den Ansprüchen 2 und 3, **dadurch gekennzeichnet, daß** in der Einrichtung zum Bilden der Blocksicherungsinformationen (EBV) bei Vorhandensein eines Termes bei einem ersten von jeweils zwei Registern (R) zugeordneten Gliedern des Binärcodepolynoms oder bei den 2 bis k fehlenden Binärcode-Polynomgliedern zwischen jeweils zwei Registern (R) einer Registerkette (RK1, RK2) an der Stelle, die durch die Anzahl m des ersten und der fehlenden Glieder zwischen dem vorhergehenden Register (R) der Registerkette (RK1, RK2) und dem Auftreten des Terms definiert wird, die Information des m-ten von 1 bis k möglichen Datenbits binär mit der Ausgangsinformation der m-ten von 1 bis k möglichen Registerketten (RK1, RK2) dividiert wird und die so ermittelte Verknüpfungsinformation (VI) über jeweils einen, die Lage eines Terms repräsentierenden Ausgang (A,B,C) der Einrichtung zum Bilden der Verknüpfungsinformation (EBV) an das nach dem Auftreten des Terms jeweils folgende Verknüpfungsglied (V) der jeweiligen Registerkette (RK1, RK2) weitergeleitet wird, sowie daß bei Vorhandensein von n > 2 Termen bei und zwischen dem ersten und dem 2 bis k fehlenden Binärcode-Polynomgliedern zwischen zwei Gliedern bzw. Registern (R) von Registerketten (RK1, RK2) die ersten zwei entsprechend gebildeten Verknüpfungsinformationen (VI) je Term entsprechend der Reihenfolge ihres Vorhandenseins binär dividiert werden, daß dieses Divisionsergebnis mit den weiteren entsprechend gebildeten Verknüpfungsinformationen (VI) bei Vorhandensein weiterer Terme nacheinander entsprechend der Reihenfolge ihres Vorhandenseins binär dividiert wird, und daß die so gebildete Verknüpfungsinformation (VI) für mehrere fehlende Zwischenterme über jeweils einen eine Termkonfiguration repräsentierenden Ausgang der Einrichtung zum Bilden der Verknüpfungsinformation (EBV) zu den entsprechenden Verknüpfungsgliedern (V) weitergeleitet wird.

5. Verfahren nach den Ansprüchen 2 bis 4, **dadurch gekennzeichnet, daß** im sendeseitigen Codierwerk mittels einer im Datenbittakt (DT) der Datenbitfolge (D) die Ausgänge der Registerketten (RK1, RK2) zyklisch abtastenden Multiplexeinrichtung (MUX1) der Divisionsrest aus den Registerketten (RK1, RK2) ausgelesen und die seriell vorliegende Datenblocksicherungsinformation (BSI) mittels einer zweiten Multiplexeinrichtung (MUX2) an das Ende der Datenblockinformation angefügt wird.

6. Verfahren nach den Ansprüchen 1 bis 6, **dadurch gekennzeichnet, daß** die sendeseitig gebildete und übertragene und die empfangsseitig gebildete Datenblocksicherungsinformation (BSI) im empfangsseitigen Codierwerk auf eine Vergleichereinrichtung geführt und in dieser verglichen werden und daß aus dem die fehlerfreie oder Einzelfehler aufweisende oder Mehrfachfehler aufweisenden oder Fehlerbündel aufweisende Datenbitfolge-Übertragung anzeigenden Vergleichsergebnis eine der Übertragungsqualität entsprechende Information gebildet und am Ausgang der Vergleichereinrichtung bereitgestellt wird.

7. Verfahren nach den Ansprüchen 1 bis 6, **dadurch gekennzeichnet, daß** im empfangsseitigen Codierwerk die empfangsseitig gebildeten und in den Registerketten (RK1, RK2) gespeicherten Datenblocksicherungsinformationen (BSI) durch die sendeseitig gebildeten und übertragenen Datenblocksicherungsinformationen (BSI) binär dividiert werden, daß die an den Registerausgängen (R1 bis R32) vorliegende Divisionsrestinformation an eine Auswerteeinrichtung (AE) weitergeleitet wird, daß in der Auswerteeinrichtung (AE) die Informationen der Ausgänge aller Register (R1 bis R32) im Hinblick auf das Vorhandensein einer die binäre "0"-repräsentierenden Information ausgewertet wird und daß bei Vorhandensein der binären "0"-Information an allen Registerausgängen eine die fehlerfreie Datenbitfolge-Übertragung anzeigende Information und bei Vorhandensein unterschiedlicher binärer Informationen an den Registerausgängen eine die fehlerhafte Datenbitfolge-Übertragung anzeigende Information gebildet und zum Ausgang (AA) der Auswerteeinrichtung (AE) geleitet wird.

8. Verfahren nach den Ansprüchen 2 bis 7, **dadurch gekennzeichnet, daß** die eine binäre Division repräsentierenden Verknüpfungsglieder (V) sowie die binären Divisionsglieder (V1 bis V3) in der Einrichtung zum Bilden der Verknüpfungsinformationen (EBV) durch binäre Exklusiv-Oder-Funktionen realisiert werden.

## Claims

1. Method for data protection during the transmission of serial data bit sequences (D) by forming data block protection information items (BSI) with the aid of cyclic binary codes in each case one transmitter-end and one receiver-end coding unit, in which in each case registers (R) representing the members of the binary code polynomial and binary logic elements (V) are arranged in such a manner that the binary block protection information items are determined by means of a binary arithmetic operation by means of a message polynomial defined by the binary sequence of a data block and a binary code polynomial of a degree G, representing the cyclic binary code, and defined terms in the form of the resultant arithmetic operation remainder, are added at the transmitting end serially to the end of the data block and are supplied at the receiving end in parallel with the received block protection information items to a comparator (AE) used for the purpose of error detection, characterised in that the registers (R) are serially arranged in register chains (RK) the number K of which at least corresponds to the ratio of the bit clock of the data bit sequences (D) to the reduced processing clock (VT) of the coding unit, provided for forming the block protection information items, in that the registers (R) are distributed in the ascending order of their associated polynomial ordinal numbers 1 to G correspondingly cyclically to the register chains (RK) or, if K has been selected to be > 2, are distributed either individually or at least partially in groups to the register chains (RK), in that the register chain inputs and a number of register outputs, depending on the register chain number and on the polynomial ordinal number distribution, which is cyclic individually or in groups, of the registers (R) provided with the highest ordinal numbers, are conducted to a device for forming combinatorial information items (EBV), in that after a register (R) representing one term or between the registers (R), in dependence on the presence of at least one term, in the case of the missing members of the binary code polynomial a logic element (V) is inserted, in that a number of data bits, which is also dependent on the register chain number and on the Polynomial ordinal number distribution, which is cyclic individually or in groups, of the serial data bit sequence (D) is entered serially with the bit block rate (DT) of the data bit sequence (D) into a serial/parallel conversion device (SPU), in than the data bits are read out of the serial/parallel conversion device (SPU) with the processing clock (VT) and are forwarded via a number of lines corresponding to the number of data bits entered to the device for forming the combinatorial information items (EBV), in that in the device for forming the combinatorial information items (EBV), the respective combinatorial information items (VI) for the respective logic elements (V) are formed and are supplied via connections provided for this purpose to the individual logic elements (V) and register chain inputs, and in that the combinatorial information items (VI) are formed in dependence on the number and position of the terms at or in front of the registers (R) of the register chain (RK) of members of the binary code polynomial in each case missing in the series of polynomial ordinal numbers, by binary arithmetic operations by means of the information items present at the outputs of the registers (R) provided with the highest polynomial ordinal numbers and containing the data bits, within one processing clock period (VT).

2. Method according to Claim 1 characterised in that the number of serially connected registers (R) is selected to be equal for each register chain (RK1, RK2), in that the number K of the register chains (RK1, RK2) corresponds to an integral part of the degree G of the binary code polynomial and that the polynomial ordinal numbers are individually cyclically allocated to the register chains (RK1, RK2).

3. Method according to one of the preceding claims, characterised in that with a number K of register chains (RK1, RK2), which exhibits the same number of registers (R) and corresponds to an integral part number of the degree G of the binary code polynomials, the polynomial ordinal numbers per register chain (RK1, RK2) are allocated in accordance with the order $n, n+k, n+2k..+n+(G/k-1)k$, in which n corresponds to the register chain number allocated to the respective register chain (RK1, RK2).

4. Method according to Claims 2 and 3, characterised in that in the device for forming the block protection information items (EBV), with the presence of a term in members of the binary code polynomial allocated to a first one of in each case two registers (R) or in the 2 to k missing binary code polynomial members, between in each case two registers (R) of a register chain (RK1, RK2), at the point which is defined by the number m of the first and of the missing members between the preceding register (R) of the register chain (RK1, RK2) and the occurrence of the term, the information of the mth of 1 to k possible data bits is divided by binary means by the output information of the mth of 1 to k possible register chains (RK1, RK2) and the combinatorial information (VI) thus determined is forwarded via in each case one output (A,B,C), representing the position of a term, of the device for forming the combinatorial information (EBV) to the logic element (V), in each case following after the occurrence of the term, of the respective register chain (RK1, RK2), and that with the presence of n > 2 terms at and between the first and the 2 to k missing binary code polynomial members between two members or registers (R) of register chains (RK1, RK2), the first two correspondingly formed combinatorial information items (VI) per term are divided by binary means in accordance with the order of their presence, that this result of the division is divided by binary means by the further combinatorial information items (VI), correspondingly formed, with the presence of further terms, successively in accordance with the order of their presence and that the combinatorial information (VI) thus formed for several missing intermediate terms is forwarded via in each case one output, representing a term configuration, of the device for forming the combinatorial information (EBV) to the corresponding logic elements (V).

5. Method according to Claims 2 to 4, characterised in that in the transmitting-end coding unit, the division remainder is read out of the register chains (RK1, RK2) by means of a multiplex device (MUX1) cyclically sampling the outputs of the register chains (RK1, RK2) at the data bit rate (DT) of the data bit sequence (D) and the serially present data block protection information (BSI) is attached to the end of the data block information by means of a second multiplex device (MUX2).

6. Method according to Claims 1 to 5, characterised in that the data block protection information (BSI) formed at the transmitting end and transmitted and the data block protection information (BSI) formed at the receiving end are conducted to a comparator device in the receiving-end coding unit and are compared in this comparator device and in that from the comparison result indicating the data bit sequence transmission which is error free or exhibits individual errors or exhibits multiple errors or exhibits error bursts, an information corresponding to the transmission quality is formed and provided at the output of the comparator device.

7. Method according to Claims 1 to 6, characterised in that in the receiving-end coding unit, the data block protection information items (BSI) formed at the receiving end and stored in the register chains (RK1, RK2) are divided by binary means by the data block protection information items (BSI) formed at the transmitting end and transmitted, that the division remainder information present at the register outputs (R1 to R32) is forwarded to an evaluating device (AE), that in the evaluating device (AE) the information items of the outputs of all registers (R1 to R32) are evaluated with respect to the presence of an information representing the binary "0", and that with the presence of the binary "0" information at all register outputs, an information indicating the error-free data bit sequence transmission and with the presence of different binary information items at the register outputs an information indicating the errored data bit sequence transmission is formed and conducted to the output (AA) of the evaluating device (AE).

8. Method according to Claims 2 to 7, characterised in that the logic elements (V) representing a binary division and the binary division members (V1 to V3) in the device for forming the combinatorial information items (EBV) are implemented by binary exclusive-OR functions.

**Revendications**

1. Procédé pour protéger des données lors de la transmission de suites (D) de bits de données en série, moyennant la formation d'informations (ASI) de protection des blocs de données à l'aide de codes binaires cycliques dans des unités de codage prévues respectivement côté émission et côté réception et dans lesquelles respectivement des registres (R) et des circuits combinatoires binaires (V), qui représentent les éléments du polynôme du code binaire sont disposés de telle sorte que les informations binaires de protection des blocs sont déterminées au moyen d'une opération de calcul binaire avec un polynôme d'information défini par la suite binaire d'un bloc de données, et par un polynôme du code binaire représentant le code binaire cyclique et possédant un degré G et des termes définis sous la forme du reste obtenu de l'opération de calcul, et sont ajoutées en série, côté émission, à la fin du bloc de données et sont envoyées, côté réception, en parallèle avec les informations reçues de protection des blocs à un comparateur (AE) utilisé pour l'identification d'erreurs, caractérisé par le fait

que les registres (R) sont disposés les uns à la suite des autres dans des chaînes de registres (RK), dont le nombre k correspond au moins au rapport de la cadence binaire de la suite (D) des Dits de données à la cadence réduite de traitement (VT), prévue pour l'information des informations de protection des blocs, de l'unité de codage, que les registres (R) sont répartis cycliquement de façon correspondante dans les chaînes de registres (RK) dans l'ordre croissant des numéros d'ordre 1 à G du polynôme, qui leur sont associés, ou, dans la mesure où on choisit k > 2, sont répartis soit individuellement, soit au moins en partie par groupes dans les chaînes de registres (Rk), que les entrées des chaînes de registres et un nombre, qui dépend de la répartition individuelle ou de la répartition cyclique par groupe des numéros d'ordre du polynôme, de sorties des registres (T) possédant les numéros d'ordre les plus élevés, sont raccordées à un dispositif servant à former des informations de combinaison (EBV), qu'un circuit combinatoire (V) est inséré en aval d'un registre (R) représentant un terme ou entre les registres (R) en fonction de la présence d'au moins un terme dans le cas où des éléments du polynôme du code binaire manquent, qu'un nombre, qui dépend également du nombre de chaînes de registres et de la distribution individuelle ou de la distribution cyclique par groupe des numéros d'ordre du polynôme, de bits de données de la suite en série de bits de données (D) sont introduits en série avec la vitesse (DT) de la cadence binaire de la suite de bits de données (D) dans un dispositif de conversion série/parallèle (SPU), que les Dits de données sont lus à partir du dispositif de conversion série/parallèle (SPU), à la cadence de traitement (VT) et sont envoyés, par l'intermédiaire d'un nombre de lignes correspondant au nombre des bits de données introduits, au dispositif servant à former les informations de combinaison (EBV), que dans le dispositif servant à former les informations de combinaison (EBV), les informations de combinaison respectives (VI) sont formées pour les circuits combinatoires respectifs (V) et sont envoyées par l'intermédiaire de liaisons prévues à cet effet, aux différents circuits combinatoires (V) et aux différentes entrées des chaînes de registres, et que les informations de combinaison (VI) sont formées, en fonction du nombre et de la position des termes dans ou en amont des registres (R) de la chaîne de registres (RK), respectivement selon la série des numéros d'ordre d'éléments manquants du polynôme du code binaire, au moyen d'opérations de calcul binaire, à l'aide des informations présentes sur les sorties des registres (R) possédant les numéros d'ordre les plus élevés du polynôme et contenant les bits de données, et ce pendant une période (VT) de la cadence de traitement.

2. Procédé suivant la revendication 1, caractérisé par le fait que le nombre de registres (R) branchés en série est choisi identique dans chaque chaîne de registres (RK1, RK2), que le nombre k des chaînes de registres (RK1,RK2) correspond à une partie, formée d'un nombre entier, du degré (G) du polynôme du code binaire et que les numéros d'ordre du polynôme sont affectés individuellement et cycliquement aux chaînes de registres (RK1,RK2).

3. Procédé suivant l'une des revendications précédentes, caractérisé par le fait que dans le cas d'un nombre k, qui correspond à une valeur partielle, formée d'un nombre entier, du degré G du polynôme du code binaire, de chaînes de registres (RK1,RK2) contenant le même nombre de registres (R), les numéros d'ordre du polynôme sont associés conformément à la séquence $n, n+k, n+2k ... n+(G/k-1)k$ pour chaque chaîne de registres (RK1,RK2), les nombres de chaînes de registres associées aux chaînes respectives de registres (RK1, RK2) se correspondant.

4. Procédé suivant les revendications 2 et 3, caractérisé par le fait que dans le dispositif servant à former les informations (EBV) de protection des blocs, lors de la présence d'un terme dans un premier membre faisant partie de membres du polynôme du code binaire, associés respectivement à deux registres (R), ou dans le cas des 2 à k membres manquants du polynôme du code binaire entre deux registres respectifs (R) d'une chaîne de registres (RK1,RK2), à la place qui est définie par le nombre m du premier membre et des membres manquants entre le registre (R) précédent de la chaîne de registres (RK1,RK2) et l'apparition du terme, l'information du m-ème bit de données, qui fait partie de 1 à k bits de données possibles, est divisée en binaire par l'information de sortie de la m-ème chaîne de registres faisant partie de 1 à k chaînes de registres possibles (RK1, RK2), et l'information de combinaison (VI) ainsi obtenue est transmise par l'intermédiaire respectivement d'une sortie (A, B, C) représentant la position d'un terme, du dispositif servant à former l'information de combinaison (EBV), au circuit combinatoire (V), qui suit respectivement l'apparition du terme, de la chaîne respective de registres (RK1,RK2), et que dans le cas de l'existence N > 2 termes, pour et entre le premier membre du polynôme du code binaire manquant et le 2 à k-ème membres manquants du polynôme du code binaire entre deux circuits ou registres (R) de chaînes de registres (RK1,RK2), les deux premières informations de combinaison (VI) formées de façon correspondante sont divisées en binaire, pour chaque terme, conformément à la succession de présence, que ce résultat de division est divisé par les autres informations de combinaison (VI) formées de façon correspondante est divisé en binaire, dans le cas de la présence d'autres termes, successivement d'une manière correspondant à la succession de leur présence et que l'information de combinaison (VI) ainsi formée est retransmise, pour plusieurs termes intermédiaires manquants, par l'intermédiaire d'une sortie respective, qui représente une configuration de termes, du dispositif servant à former l'information de combinaison (BV), aux circuits combinatoires correspondants (V).

5. Procédé suivant les revendications 2 à 4, caractérisé par le fait que dans l'unité de codage située du côté émission, le reste de division est lu à partir des chaînes de registres (RK1,RK2), à l'aide d'un dispositif de multiplexage (MUX1), qui explore cycliquement les données des chaînes de registres (RK1,RK2), à la cadence (DT) des bits de données de la séquence de bits de données (D), et l'information (VSI) de protection des blocs de données, qui est présente en série, est ajoutée, au moyen d'un second dispositif de multiplexage (MUX2), à la fin de l'information des blocs de données.

6. Procédé suivant l'une des revendications 1 à 5, caractérisé par le fait que l'information (BSI) de protection des blocs de données formée et transmise côté émission et une information (BSI) de protection des blocs de données formée côté réception sont envoyées, dans l'unité de codage située côté réception, à un dispositif comparateur et sont comparées dans ce dernier et une information correspondant à la qualité de transmission est formée à partir du résultat de la comparaison indiquant la transmission de la suite de bits de données exempte d'erreurs ou comportant des erreurs individuelles ou des erreurs multiples ou des groupes d'erreurs.

7. Procédé suivant l'une des revendications 1 à 6, caractérisé par le fait que dans l'unité de codage située côté réception, les informations (BSI) de protection des blocs de données formées côté réception et mémorisées dans les chaînes de registres (RK1,RK2) sont divisées en binaire par les informations (BSI) de protection des blocs de données formées et transmises côté émission, que l'information du reste de la division, qui est présent sur les sorties (R1 à R32), est envoyée à un dispositif d'évaluation (AE), que dans le dispositif d'évaluation (AE), les informations des sorties de tous les registres (R1 à R32) concernant la présence d'une information représentant le zéro binaire sont évaluées et que dans le cas de la présence de l'information "0" binaire sur toutes les sorties des registres, une information indiquant la transmission de la suite de bits de données sans erreur et, dans le cas de la présence d'informations binaires différentes sur les sorties des registres, une information indiquant la transmission défectueuse de la suite de bits de données est formée et est envoyée à la sortie (AA) du dispositif d'évaluation (AE).

8. Procédé suivant les revendications 2 à 7, caractérisé par le fait que les circuits combinatoires (V) représentant une division binaire ainsi que les circuits de division binaire (V1 à V3) possédant le dispositif servant à former les informations de combinaison (EBV) sont formés au moyen de fonctions OU-Exclusif binaires.